# EUROPEAN PATENT APPLICATION

(11) **EP 1 947 211 A1**
(43) Date of publication of application: **23.07.2008**
(21) Application number: 06425820.5
(22) Date of filing: 05.12.2006
(51) Int. Cl.: C23C 14/50, C23C 14/56, C23C 16/455

(54) **Vacuum metallization device**

(71) Applicant: Galileo Vacuum Systems S.p.A., 59100 Prato (IT)
(72) Inventor: Fanfani, Stefano, 50129 Firenze (IT)
(74) Representative: Mannucci, Michele

(57) **Abstract**

The vacuum metallization device comprises a vacuum chamber (3, 5A) and a pumping system to create the vacuum in the chamber. Positioned inside said vacuum chamber are at least one vaporization source (113), at least two electrodes (51) spaced apart from one another, at least one diffuser (53, 55) to introduce a fluid into the vacuum chamber, a plurality of holders (9) for the parts to be metallized, which move in said chamber. The diffuser and said at least two electrodes are positioned spaced apart from one another so as to generate between said two electrodes an electrical field that involves at least part of the inner volume of the vacuum chamber in which said holders move, and to make molecules of the fluid introduced by the diffuser interact with said electrical field in the volume of the vacuum chamber in which the part holders move.

## Description

### Technical field

The present invention relates to vacuum metallization devices. More specifically, the invention relates to improvements to vacuum metallization devices of the batch type, i.e. in which batches of products positioned inside a vacuum chamber are metallized in successive cycles.

In particular, the invention relates to metallization machines or devices also provided with systems to produce polymer coatings applied to processed parts after metallization.

### Prior Art

To perform metallization on parts processed in batches it is customary to utilize devices or machines including a vacuum chamber, usually cylindrical in shape or similar, inside which the parts are placed on specific holders. The holders are provided with a movement inside the volume of the vacuum chamber, so that the parts positioned thereon are metallized uniformly. The metallization layer is obtained by means of evaporation of a metal, typically aluminum, heated by Joule effect.

WO-A-03/076684 describes a metallization device of this type. The vacuum chamber is composed of a fixed chamber portion and one or other of two ports, or moving parts, which are closed alternately on the fixed part. In this way, while one batch of products is metallized inside the vacuum chamber, the batch processed in the previous cycle can be unloaded and replaced by a new batch of parts to be processed in the subsequent cycle. For this purpose, the part holders are located in the moving parts or ports of the vacuum chamber, so that the system is provided with two groups of independent holders utilized alternately.

WO-A-03/076684 describes a similar device, comprising a special mechanism to provide the part holder with planetary motion.

A similar metallization device is described in WO-A-03/018865.

To carry out metallization, inside the vacuum chamber a metal charge is placed, which usually composed of aluminum bars or wires placed inside heating sources. WO-A-03/076682 describes a special system of contacts to electrically supply the vaporization sources. This publication also describes a system of contacts to electrically supply a high voltage electrode to generate an electrical field inside the vacuum chamber. This electrical field is utilized in a preliminary step that precedes the actual metallization to activate the surface of the parts to be metallized using a glow discharge, obtained by means of the electrical field generated by the electrode, and of a flow of inert gases, typically nitrogen, argon or the like, which is introduced into the vacuum chamber in the preliminary processing step.

The high voltage electrode inside the metallization chamber is also used to perform further processing operations on the parts after metallization thereof. Typically, the metallized parts are coated with a coating of polymer material obtained by polymerization of monomers introduced into the vacuum chamber by means of a specific diffuser, with energy supplied by the high voltage electrode.

WO-A-2004/005576 describes an arrangement of an electrode and of a first inert gas diffuser to carry out the preliminary surface-activation treatment, and of a second diffuser to introduce the monomers to be used to form the polymerization coating. The electrode and the diffuser(s) are partially surrounded by a semi-cylindrical protective screen and located in a central position inside the vacuum chamber, in the area inside the path of the part holders.

US-A-5,970,908 describes a similar metallization device, in which the electrode(s) and the diffusers are housed in perimeter recesses provided along the wall of the vacuum chamber. In this case, the chamber preferably has a cylindrical shape and a vertical layout.

US-A-4,956,196 describes a vacuum metallization device, in which the vacuum chamber is positioned with the axis horizontal and the parts are loaded onto a cart which is inserted axially in the chamber.

To obtain a sufficient degree of vacuum in the metallization chamber, in these machines or devices a combination of vacuum pumps of various types are used. Typically, at least a first mechanical primary pump and at least a diffusion pump are associated with the vacuum chamber. US-A-4,956,196 describes an arrangement of pumps comprising a volumetric pump, a mechanical lobe pump and a diffusion pump. The diffusion pump can only operate when an adequate degree of vacuum has been reached in the vacuum chamber, which in the preliminary step, i.e. the step which precedes the actual metallization cycle, is obtained by means of the mechanical pumps and/or of the roots pumps. For this purpose, in the first step of evacuation of the vacuum chamber, after it has been loaded with the parts to be processed and closed, the diffusion pump is kept isolated from the vacuum chamber, until a degree of vacuum, for example in the order of 1x10⁻² mbar, has been reached therein. At higher pressures the diffusion pump cannot be primed. Therefore, in these systems a connection is provided so that in the first evacuation step, the vacuum chamber is in connection with the suction of the mechanical or primary pumps and in a second step with the diffusion pump, the discharge of which is connected to the primary pumps.

During the preliminary step for surface activation of the parts and during the conclusive step to coat the metallized parts with a polymer coating, gaseous products are introduced into the vacuum chamber with a consequent increase in the pressure value, making it necessary to deactivate the diffusion pump and isolate it from the inside of the vacuum chamber.

Normally, cryogenic panels or cryogenic pumps are also associated with the vacuum chambers. These are devices equipped with heat exchangers, which are kept at very low temperature and on which the molecules of water vapor present in the vacuum chambers condense. The cryogenic panels can operate at pressures in the order of 2-3 mbar and can consequently be made to operate even before the pressure required to prime the diffusion pumps has been reached inside the vacuum chamber. Normally, the cryogenic panel is positioned between the diffusion pump and a valve or damper that isolates the inside of the actual vacuum chamber from the area in which the cryogenic panel is located and from the suction of the diffusion pump. With an arrangement of this type, described for example in US-A-4,956,196, the cryogenic panel and the diffusion pump can be made to operate only when the required degree of vacuum (in the order of 1x10⁻² mbar) at which the diffusion pump can start to operate is reached.

### Objects and summary of the invention

According to a first aspect, an object of the invention is to provide a device or machine for vacuum metallization of parts in batches with a particularly compact structure.

According to a different aspect, an object of the invention is to provide a machine or device for vacuum metallization of parts in batches that allows optimal metallization and coating cycles to be carried out, making better use, compared with conventional devices, of the various evacuation devices (primary pumps, diffusion pumps, cryogenic panels) as a function of the degree of vacuum reached inside the vacuum chamber and of the steps of the operating cycle that take place inside said chamber.

According to a first aspect, the invention provides for a vacuum metallization device, including a vacuum chamber and a pumping system to create the vacuum in said chamber. In this device, positioned inside said vacuum chamber are at least one vaporization source, at least two electrodes spaced apart from one another, at least one diffuser to introduce a fluid into the vacuum chamber, a plurality of holders for the parts to be metallized, which move in said chamber. Moreover, said at least one diffuser and said at least two electrodes are positioned spaced apart from one another so as to generate between said two electrodes an electrical field that involves at least part of the inner volume of the vacuum chamber in which said holders move, and to make molecules of said fluid introduced by said diffuser interact with said electrical field in said part of the volume of the vacuum chamber in which the holders move.

A particularly compact machine is obtained with this arrangement of the diffuser and of the electrodes. In fact, while in conventional machines the electrode(s) or the diffuser(s) are usually positioned in proximity to one another and protected by a screen to generate in an area of the machine the plasma which is then diffused in the area in which the parts to be processed are located, according to the invention the molecules of fluid introduced by the diffuser into the chamber are energized by the electrical field generated by the electrodes inside the chamber directly in the volume through which the part holders travel with a substantial saving of space.

According to a particularly advantageous embodiment, the diffuser and the electrodes are positioned inside the vacuum chamber substantially at the vertices of a triangle. Preferably, two of said vertices are adjacent to the side wall of the vacuum chamber and preferably in the fixed portion of the vacuum chamber. Conversely, the diffuser can be positioned in a central area of the chamber or also along the wall of the vacuum chamber and in this case preferably along the portion of wall of the vacuum chamber constituted by the movable port of said chamber.

According to an advantageous embodiment, the holders for the parts to be metallized are provided with a planetary movement about an axis of the vacuum chamber, preferably a substantially vertical axis. In this case the electrodes and the diffuser preferably extend in a direction substantially parallel to the axis and therefore preferably also in a vertical direction.

The machine or device according to the invention can include a vacuum chamber constituted by a cylindrical wall with a horizontal axis, with a fixed base and a moving base on which the part holders are supported, which in this case will be inserted into the wall of the chamber with a movement parallel to the axis of said chamber in a configuration substantially know, for example, from US-A-5,970,908. Nonetheless, the machine will preferably be of the type comprising a chamber composed of an approximately semi-cylindrical or semi-prismatic fixed portion provided with two ports or moving parts, also preferably semi-cylindrical or semi-prismatic, which alternately close the vacuum chamber and each supporting a series of holders for parts to be metallized, all as substantially know, for example, from WO-A-03/076684 or WO-A-2004/005576, the vacuum chamber being provided with a substantially vertical axis.

In a preferred embodiment of the present invention, the metallization machine or device comprises four part holders for the parts to be processed. When the machine is configured with two moving parts or ports to close the vacuum chamber, each moving part will preferably be provided with four part holders, provided with a planetary movement about the axis of the vacuum chamber.

Advantageously, according to a possible embodiment, the device can include a primary pumping unit with one or more mechanical pumps in series, combined with at least one diffusion pump and at least one cryogenic panel. In this case, the diffusion pump is connected to the inside of the vacuum chamber by means of a suction duct, positioned along which is a first valve, in particular a shut-off gate valve to isolate the diffusion pump from a volume inside which the cryogenic panel is located. This panel can advantageously be housed in a suction prechamber in turn isolatable from the inside of the vacuum chamber by means of a second shut-off valve. In this way it is possible to place only the cryogenic panel or both the cryogenic panel and the diffusion pump in communication with the vacuum chamber. This makes it possible to utilize the cryogenic panel during the operating steps of the metallization cycle, during which the degree of vacuum inside the metallization chamber is not sufficiently high to keep the diffusion pump operating. In this way it is possible to carry out a method of metallization and subsequent protection by means of coating the metallized parts comprising the steps of:
➢ placing the parts to be metallized in the vacuum chamber;
➢ generating in said vacuum chamber a degree of vacuum sufficient for metallization, by means of at least a primary pump and a diffusion pump;
➢ metallizing the parts keeping said degree of vacuum in said chamber;
➢ at the end of the metallization step, isolating the diffusion pump from the inside of the vacuum chamber and introducing into said vacuum chamber at least a first fluid to form a protective coating of the metallization layer formed on the parts, keeping a cryogenic panel active to reduce the presence of dampness in said vacuum chamber, while said diffusion pump is kept isolated from said vacuum chamber.

According to a different aspect, with the aforesaid device it is possible to carry out a method of metallization comprising the steps of:
- placing the parts to be metallized in the vacuum chamber;
- generating a first degree of vacuum in said vacuum chamber by means of at least one primary pump;
- activating a cryogenic panel in connection with the inside of said vacuum chamber;
- further increasing the degree of vacuum from said first degree of vacuum to a second degree of vacuum, sufficient to activate at least one diffusion pump;
- reaching a sufficient degree of vacuum for metallization;
- metallizing the parts keeping said degree of vacuum in said chamber.

According to a different aspect, the invention also relates to a vacuum metallization device comprising a vacuum chamber and a pumping system with at least a primary pump, a diffusion pump and a cryogenic panel, characterized in that the diffusion pump is connected to the inside of the vacuum chamber by means of a suction duct and in that positioned along the suction duct is a first shut-off valve to isolate the vacuum pump from a volume, inside which the cryogenic panel is located, said volume being in connection with the vacuum chamber.

In this case the volume in which cryogenic panel is located will preferably be isolatable from the inside of the vacuum chamber by means of a second shut-off valve.

According to an advantageous embodiment, the first shut-off or gate valve comprises a closing member movable in a plane substantially orthogonal to the suction duct of the diffusion pump. The movement is preferably an oscillatory movement, although it would also be possible for this shut-off valve to be provided with a translatory movement.

In a possible embodiment, also the second shut-off valve, which separates the inside of the vacuum chamber from the volume, in which the cryogenic panel is located, can comprise an oscillating closing member.

The arrangement of the aforesaid valves can advantageously be used also with a different arrangement of the inner members of the vacuum chamber, for example, without electrodes and/or diffusers, or with a different number of diffusers and/or electrodes from the number defined above and described below in detail with reference to a possible embodiment.

Further advantageous features and embodiments of the device according to the invention and of the methods implementable therewith are described in the appended claims and in the detailed description below of a non-limiting embodiment of the invention.

### Brief description of the drawings

The invention will be better understood by following the description and accompanying drawing, which shows a non-limiting practical embodiment of the invention. More specifically, in the drawing:
Figure 1 shows a side view of a device incorporating the present invention;
Figure 2 shows a plan view according to II-II in Figure 1;
Figure 3 shows an enlargement of the side view in Figure 1;
Figure 4 shows a section of the volume containing the cryogenic panel;
Figure 5 shows a view according to V-V in Figure 4;
Figures 6 and 7 show sections according to VI-VI and VII-VII in Figure 5;
Figure 8 shows the pressure trend in a typical processing cycle; and
Figure 9 shows a diagram of the kinematic movement of the part holder in a possible improved embodiment.

### Detailed description of embodiments of the invention

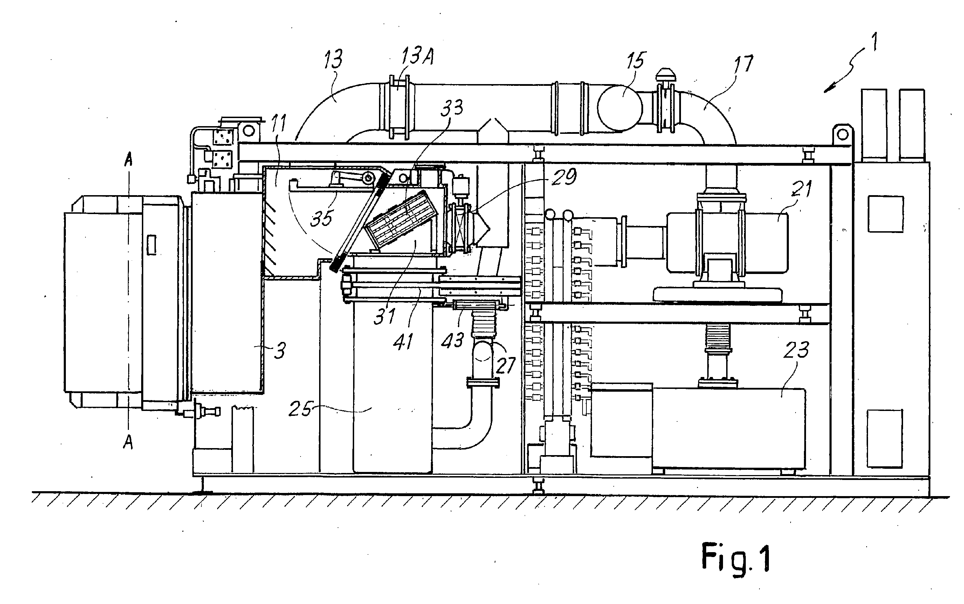

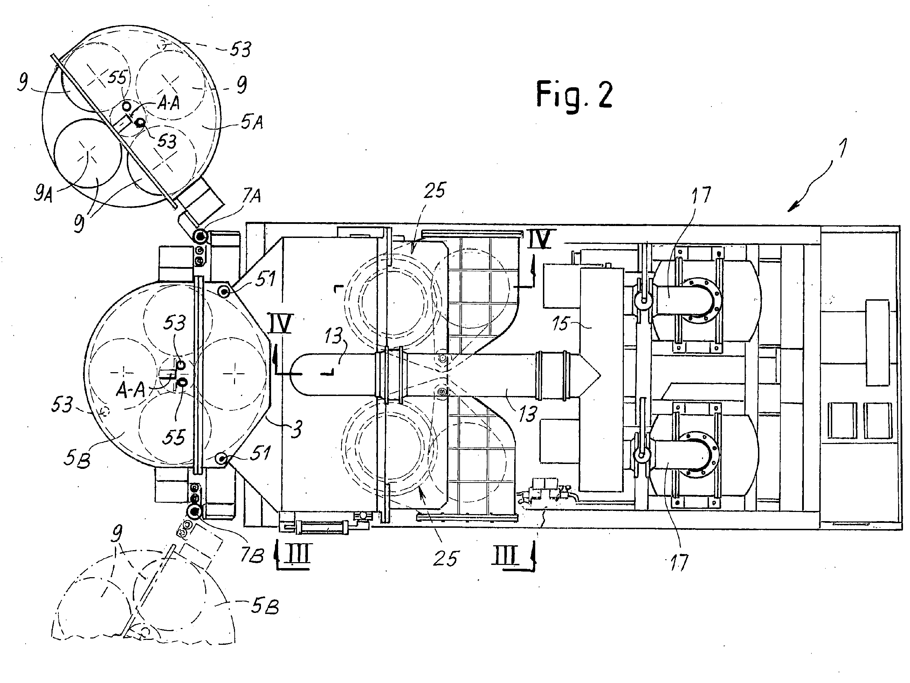

With initial reference to Figures 1 and 2, the device represented herein and generically indicated with 1 comprises a vacuum chamber or metallization chamber with a substantially cylindrical or prismatic-cylindrical shape with a substantially vertical axis. The vacuum chamber comprises a first fixed portion 3 hinged to which are two moving portions 5A and 5B forming ports to close the vacuum chamber. The references 7A and 7B indicate the hinges with which the moving portions 5A, 5B are constrained to the fixed portion 3.

In a way known per se, the actual vacuum chamber is formed by bringing one or other of the moving portions 5A, 5B to close the fixed portion 3, as shown in particular in Figure 2, where the moving portion 5B is closed against the fixed portion 3 (the open position thereof is indicated with a dashed line) and the other moving portion 5A is open and accessible to load the subsequent batch of parts to be processed onto the part holders associated with said moving portion, while the current batch is being processed in the vacuum chamber.

According to an advantageous embodiment part holders, indicated schematically at 9, are associated with each of the moving portions 5A, 5B. Preferably, four holders 9 are associated with each moving portion 5A, 5B, each of which is configured as a series of part-holder elements rotating about their own axis indicated with 9A and, with a planetary motion, about a central axis A-A of the respective portion 5A, 5B. When the moving portion 5A or 5B is closed, the axis A-A constitutes the vertical axis of the vacuum chamber. The planetary movement can be transmitted to the four part holders 9 with any one of the mechanisms known per se, utilized to move part holders in this type of machine. A non-limiting embodiment of these devices is illustrated in WO-A-03/076684 or in WO-A-03/018865.

Connected to the inner volume of the vacuum chamber formed by the fixed portion 3 and by one or other of the two moving portions 5A, 5B is a prevacuum volume 11 connected by means of a suction duct 13 to a manifold 15 connected, by means of ducts 17, with two substantially identical primary pumping units 19. As shown in particular in Figure 1, in an advantageous embodiment each primary pumping unit 19 comprises a root pump 21 and a mechanical pump 23 positioned in sequence, so that the root pump draws from the duct 17 and the discharge thereof is in connection with the suction of the mechanical pump 23, the discharge of which is in turn in connection with the ambient pressure.

A pair of diffusion pumps 25 are also connected to the prevacuum chamber 11. The discharge of the diffusion pumps 25 is connected by means of a duct 27 to the suction duct 13 for the purposes described below. It must be understood that, rather than a double arrangement of pumping units, a single pumping system comprising, for example, a single pump 23, a single pump 21 and a single pump 25 can be associated with the vacuum chamber with an arrangement of the suction ducts substantially identical to the one described.

The suction duct 27 is also connected in 29 to the prevacuum chamber 11.

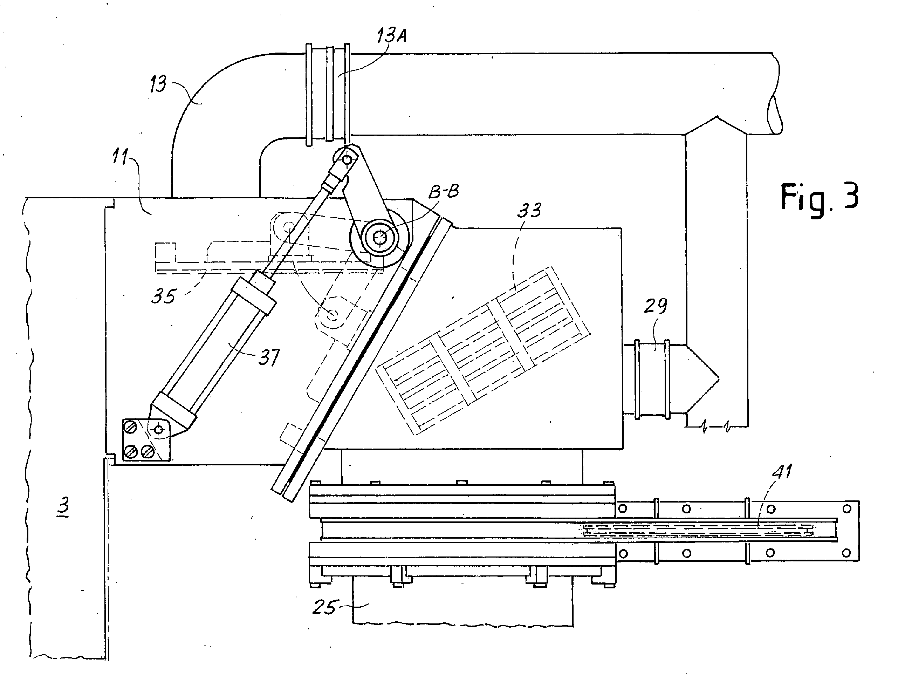

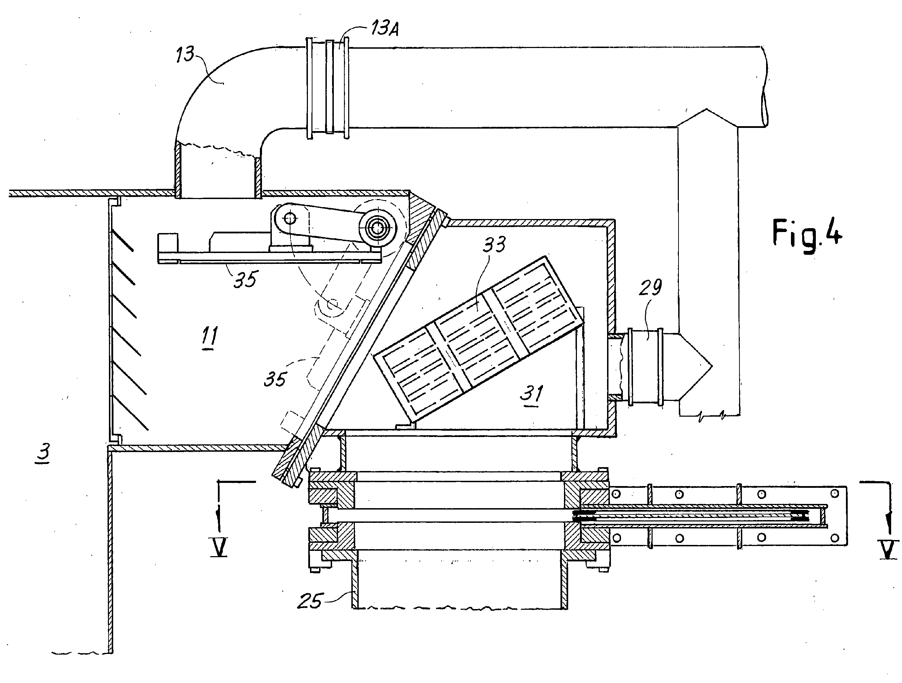

A volume 31 is formed inside the prevacuum chamber 11, in which at least one cryogenic panel or cryogenic pump 33 is housed. The volume 31 can be isolated from the volume inside the vacuum chamber by means of a shut-off valve 35 with a closing member oscillating about a substantially horizontal axis, with an arrangement shown in greater detail in Figures 3 and 4.

The oscillation of the shut-off valve 35 between an open position and a closed position, both shown in Figure 4 (with solid line and dashed line respectively), is controlled by means of a piston-cylinder actuator 37 which controls the oscillating movement of the closing member of the valve about the axis B-B.

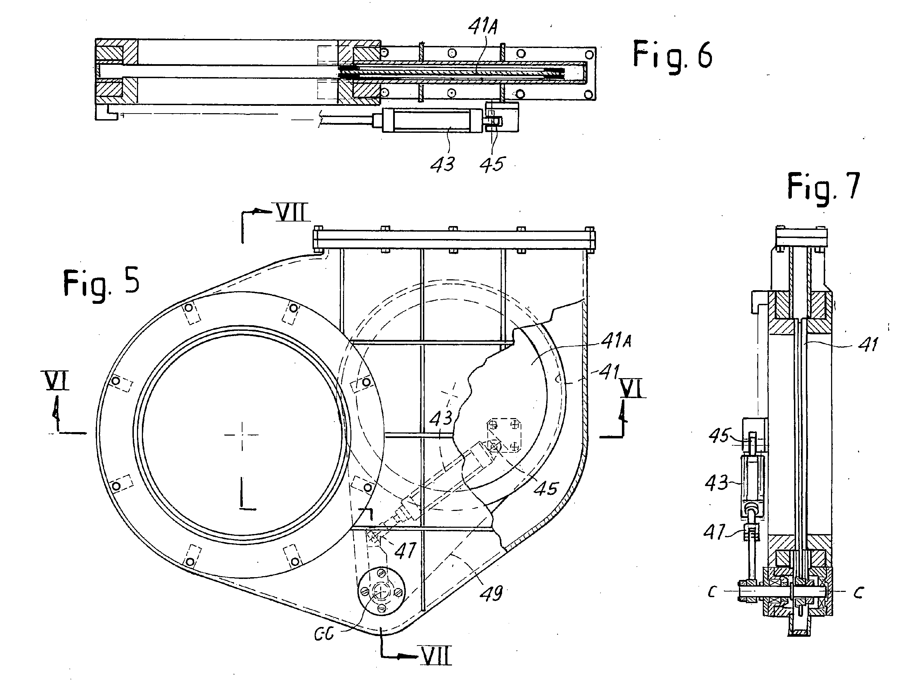

Besides being connectable with the inside of the vacuum chamber when the valve 35 is open, the volume 31 is also connectable with the suction of each of the diffusion pumps 25 or isolatable therefrom. For this purpose, a further shut-off valve 41 is provided for each of the two diffusion pumps 25. The arrangement of the shut-off valve 41 is illustrated in greater detail in Figures 4-7.

In an advantageous embodiment, the shut-off valve 41 is movable in a substantially horizontal plane, i.e. substantially orthogonal to the axis of the corresponding diffusion pump 25. The opening and closing movement of the shut-off valve 41 is controlled, for example, by a piston-cylinder actuator 43 constrained in 45 to a fixed structure and in 47 to an arm 49 oscillating about an axis C-C and integral with the closing member 41A of the shut-off valve 41.

The arrangement of the pumping system described above makes it possible to perform, for example, the following depressurization cycle of the vacuum chamber once this has been closed by one or other of the moving portions 5A, 5B in combination with the fixed portion 3, and with the parts to be metallized inside said chamber.

In a first step, the valve 35 is closed, so that the diffusion pumps 25 and the cryogenic panel 33 are isolated from the inside of the vacuum chamber 3, 5A or 3, 5B. By means of the pumps 21 and 23 a first evacuation step of the vacuum chamber is carried out by suction through the duct 13, with the valve 13A open, the manifold 15 and the ducts 17. The valve 41 can be open and the valve 29 closed, so that adequate vacuum pressure is created in the volume 31 in which the cryogenic panel 33 is located and said panel 33 can be taken to low temperature. When a sufficient degree of vacuum has been reached inside the chamber, i.e. in the order of 2 - 3 mbar, the cryogenic panel 33 can be placed in connection with said vacuum chamber. Therefore, the valve 35 can be opened to place the volume 31, in which the cryogenic panel 33 is located, in communication with the inner volume of the vacuum chamber 3, 5A or 3, 5B. Prior to this the valve 41 is closed and the valve 29 is opened. Opening of the valve 35 can be followed by closing of the valve 13A. Alternatively, the valve 41 can always be kept closed from start up of the system and the valve 29 open. The cryogenic panel taken to low temperature allows the molecules of humidity present inside the vacuum chamber to condense on the heat exchange surfaces thereof. The pressure therein, in the pre-vacuum chamber 11 and in the volume 31 is not yet sufficient to make the diffusion pumps 25 operate. Therefore, the degree of vacuum is lowered further utilizing only the primary mechanical pumps 21 and 23. Suction can take place in this step through the valve 29 positioned behind the cryogenic panel 33.

When a degree of vacuum in the order, for example, of 1x10⁻² mbar has been reached inside the vacuum chamber 3, 5A or 3, 5B, the diffusion pump 25 can be primed. For this purpose the shut-off valve 41 is opened and the valve 29 is closed. In this way the suction performed by the primary pumps 21, 23 is applied to the discharge of the diffusion pumps 25 by means of the suction ducts 27, so that the vacuum is maintained inside the vacuum chamber 3, 5A or 3, 5B and in the volumes 11 and 31 through the series of pumping units formed by the diffusion pumps 25, followed by the root pumps 21 and then by the volumetric pumps 23. The cryogenic panel 33 continues to operate condensing any molecules of humidity present on the surfaces thereof.

Alternatively, the first vacuum step, up to the pressure of 1x10⁻² bar with the valve 41 closed and the valve 35 open can take place by drawing in through the valve 13A rather than through the valve 29.

With the pumps 25 operating and connected to the vacuum chamber 3, 5A or 3, 5B, the degree of vacuum required to perform metallization (typically in the order of 1x10⁻⁴ - 1x10⁻⁵ mbar) is generated and maintained therein.

As mentioned, this step can be preceded by a surface activation step, during which an inert gas is introduced into the vacuum chamber and a glow discharge is generated by means of the members described below, housed inside said chamber. In this step for surface activation of the parts to be metallized the presence of inert gas inside the vacuum chamber maintains the pressure in this area at a value (typically in the order of 1x10⁻¹ mbar) above the value required to prime the diffusion pump 25, so that the shut-off valve 41 must remain closed. Conversely, the valve 35 can be opened, so that the cryogenic panel 33 can be in fluid connection with the inner volume of the vacuum chamber 3, 5A or 3, 5B and eliminate the humidity therefrom.

Subsequent to the surface activation step and to the further metallization step inside the vacuum chamber 3, 5A or 3, 5B, the coating step can be carried out, by means of a polymer film, on the metallization provided on the parts. For this purpose the pressure inside the vacuum chamber 3, 5A or 3, 5B must be taken once again to a value (typically around 1x10⁻¹ mbar) above the degree of vacuum required to keep the diffusion pump 25 primed. Therefore, to perform the coating step the gate valve 41 is once again closed and the degree of vacuum inside the vacuum chamber 3, 5A or 3, 5B is maintained by means of the primary pumps 21, 23 through the valve 29, while the cryogenic panel 33 can remain in fluid communication by keeping the valve 35 open, to eliminate or in any case reduce the humidity content inside the vacuum chamber.

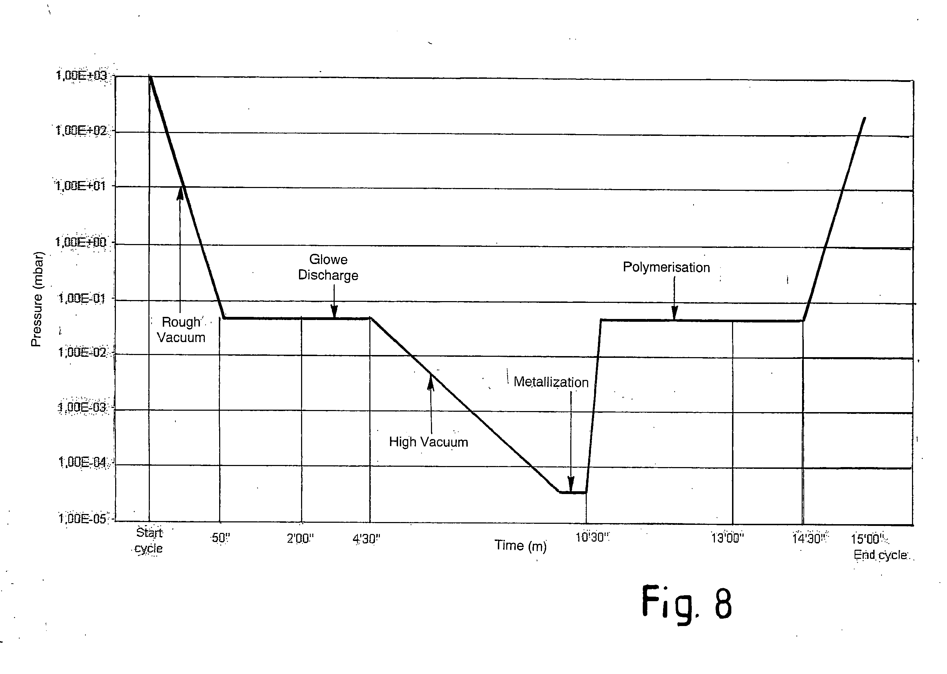

Figure 8 shows a typical pressure profile as a function of the time and of the operating steps that take place in the vacuum chamber.

From the description above it is clear that with the shut-off valves 35, 41, the diffusion pumps 25 and the cryogenic panel 33 it is possible to perform a plurality of steps in the suitable sequence inside the vacuum chamber, guaranteeing optimal operating conditions in each step. For example, contrary to what takes place in conventional devices, it is possible to perform a surface activation step and/or a surface coating step of the metallized parts keeping the cryogenic panel 33 active and isolating the diffusion pumps 25. This makes it possible to perform the coating step in particular in optimal conditions.

According to a further aspect of the invention, positioned inside the vacuum chamber formed of the fixed portion 3 and of one or other of the moving portions 5A, 5B are two high voltage electrodes indicated with 51. According to a possible embodiment, the electrodes 51 extend in a direction substantially parallel to the direction of the axis A-A of the vacuum chamber, that is, (in this configuration) in a substantially vertical direction. Preferably, they are located inside the fixed portion 3 of the vacuum chamber. According to an advantageous embodiment, illustrated in Figure 2, they are positioned approximately at the level of the two vertices of a prismatic surface forming the fixed portion 3 of the vacuum chamber.

In a possible embodiment of the invention, the electrodes 51 are preferably extending from above, i.e. fixed to the upper wall of the fixed portion 3 of the vacuum chamber and connected to a high voltage electrical line by means of a sleeve produced, for example, as described in WO-A-03/076682, the content of which is fully incorporated in the present description.

Positioned inside each of the two moving portions 5A, 5B is at least one diffuser 53. In a possible embodiment the diffuser 53 also extends parallel to the axis A-A of the vacuum chamber and therefore parallel to the electrodes 51. The diffuser 53 can be constituted, in a way known per se, by a pipe closed at one end and provided with a series of holes gradually increasing in diameter from one end of the pipe to the other. Through the other of the two ends of the pipe a gaseous product is introduced into the diffuser, which can be constituted, for example, by a monomer, with which the polymer coating is to be formed by means of the electrical field generated by the electrodes 51 located inside the vacuum chamber, in the way described below.

It would also be possible to position the diffuser 53 adjacent to the substantially semi-cylindrical wall of the respective moving portion 5A or 5B of the vacuum chamber, for example in a position indicated with a dashed line in Figure 2 (in which case the holders 9 for the parts can have a smaller dimension or the portion 5A, 5B can have a larger dimension, or a slot to house the diffuser 53 without this interfering with the movement of the parts in the vacuum chamber).

According to a possible embodiment, a further diffuser 55 can be provided, for example, beside to the first diffuser 53 in the central area of the vacuum chamber, i.e. near the axis A-A, or along the portion of semi-cylindrical wall of the corresponding moving portion 5A, 5B of the vacuum chamber. This second diffuser can be used to introduce into the vacuum chamber an inert gas to be used in the surface activation step of the parts to be metallized by generating a glow discharge. It would also be possible to utilize a single diffuser to introduce both the inert gas for the surface activation step and the monomer to produce the coating.

As can be seen in Figure 2, the electrodes 51 and the diffuser 53 are positioned at the vertices of a substantially isosceles triangle. If the diffuser 53 is positioned in proximity to the cylindrical wall of the respective moving portion 5A, 5B, the position will still be at the vertices of a triangle, preferably isosceles or equilateral.

During the step for activation of the surface of the parts, the electrodes 51 in connection with a voltage source are charged with a direct or preferably alternating voltage, and an inert gas, such as argon, nitrogen or the like, is introduced through the diffuser 55. The voltage difference between the electrodes causes a glow discharge and the accelerated gas particles bombard the surfaces of the parts positioned in the chamber activating them, i.e. facilitating bonding thereto of the metallic particles, which are vaporized in the subsequent metallization step. A surface cleaning effect also takes place in this step.

After the actual metallization step, which follows the activation step, through the diffuser 53 a monomer is introduced into the vacuum chamber while the electrodes 51 are taken to a high voltage difference with a direct or alternating voltage between the electrodes. This causes the electrical field generated to ionize the molecules of the monomer. This monomer is diffused inside the volume, in which the holders 9 supporting the parts move. The electrodes 51 and the diffuser 53 are positioned to optimize the exploitation of this volume to form the ionized monomer particles and to cause these ionized particles to bombard the metallized surfaces of the parts supported by the holders 9. The ionized particles that deposit on the metallized surfaces of the parts in movement inside the volume in which the ions are formed give rise to cross-linking and to the formation of a polymer coating, i.e. to polymerization of the metallized parts.

With the conformation described it is possible to obtain a particularly compact vacuum chamber, in which the position of the electrodes and of the diffusers makes it possible to obtain efficient processing with a high quality of surface activation - if required - and optimal polymer coating, due on the one hand to optimization of the exploitation of the inner volume of the vacuum chamber, inside which the parts are moved for ionization, and on the other hand to the possibility of maintaining the cryogenic panel 33 in operation during this coating step, with suitable switching of the valves 35 and 41.

For movement of the part holders a kinematic transmission including a chain and chain wheels of a type known per se can be provided.

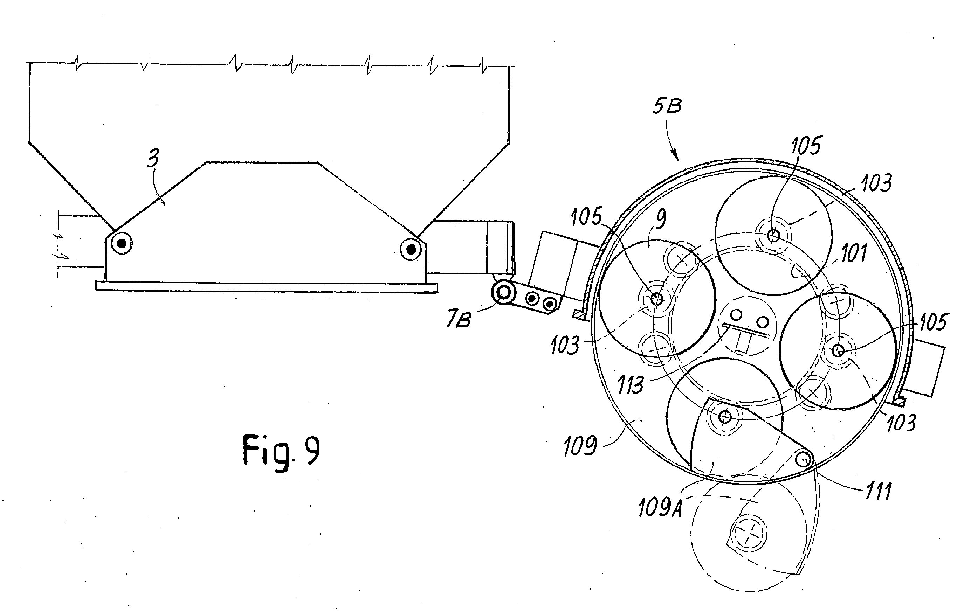

In a particularly advantageous embodiment of the invention, shown in Figure 9 and also applicable in devices with a different design of the pumping systems, the kinematic mechanism for rotation of the holders 9 comprises - for each portion 5A, 5B - a central crown gear 101, which meshes with pinions 103 in the same number as the part holders 9 (four in the example illustrated). Each pinion 103 supplies motion to a rod or shaft 105 to which the part holders 9 are constrained. The pinions 103 with the respective rods 105 are supported by superior and inferior circular rings or disks 109. In the example illustrated in Figure 9, each disk 109 each has a sector 109A hinged at 111, to take an open position indicated with a dashed line in Figure 9. One of the rods 105 is mounted on the oscillating sectors 109A of the upper and lower disks 109. This allows the holder unit 9 to open, making one of the holders 9 oscillate outward to the position shown with the dashed line, by oscillating the respective sectors 109A. This facilitates access to the central area in which the metal vaporization sources, indicated generically with 113 in Figure 9, are positioned.

Movement can also be imparted to the part holders 9 by rotating the disks 109, so that the pinions 103, meshing with the crown gear 101, for example not moving, impart a planetary motion to the holders, composed of a rotation about the axis of the ring gear 101 and of a rotation about the axis of the respective pinion 103.

It is understood that the drawing only shows an example provided by way of a practical arrangement of the invention, which can vary in forms and arrangement without however departing from the scope of the concept underlying the invention. Any reference numerals in the appended claims are provided to facilitate reading of the claims with reference to the description and to the drawing, and do not limit the scope of protection represented by the claims.

## Claims

1. A vacuum metallization device, comprising a vacuum chamber and a pumping system to create a vacuum in said chamber; wherein: positioned inside said vacuum chamber are at least one vaporization source, at least two electrodes spaced apart from one another, at least one diffuser to introduce a fluid into the vacuum chamber, a plurality of holders for the parts to be metallized, which move in said chamber; and wherein said at least one diffuser and said at least two electrodes are positioned spaced apart from one another so as to generate between said two electrodes an electrical field that involves at least part of the inner volume of the vacuum chamber in which said holders move, and to make molecules of said fluid introduced by said diffuser interact with said electrical field in said part of the volume of the vacuum chamber in which the holders move.

2. Device as claimed in claim 1, **characterized in that** said at least one diffuser and said at least two electrodes are positioned inside the vacuum chamber substantially at the vertices of a triangle.

3. Device as claimed in claim 1 or 2, **characterized in that** said holders for the parts to be metallized are provided with a planetary movement about an axis of the vacuum chamber, said electrodes and said diffuser extending in a direction substantially parallel to said axis.

4. Device as claimed in claim 1, 2 or 3, **characterized in that** said diffuser is placed in an approximately central position in said vacuum chamber.

5. Device as claimed in one or more of the previous claims, **characterized in that** said diffuser is located in an intermediate position between a plurality of holders of the parts to be metallized.

6. Device as claimed in claim 1, 2 or 3, **characterized in that** said diffuser is positioned adjacent to a side wall of the vacuum chamber.

7. Device as claimed in one or more of the previous claims, **characterized in that** said electrodes are positioned adjacent to a side wall of said vacuum chamber.

8. Device as claimed in one or more of the previous claims, **characterized in that** said vacuum chamber comprises a substantially cylindrical or prismatic side wall and **in that** said electrodes are positioned adjacent to said cylindrical or prismatic wall.

9. Device as claimed in one or more of the previous claims, **characterized in that** it comprises two diffusers to introduce two different fluids into the vacuum chamber.

10. Device as claimed in one or more of the previous claims, **characterized in that** said vacuum chamber has a substantially vertical axis, about which said part holders move.

11. Device as claimed in one or more of the previous claims, **characterized in that** said vacuum chamber comprises a first fixed portion and two moving portions, which alternately form with said fixed portion said vacuum chamber, each moving portion supporting a respective series of holders for the parts to be metallized.

12. Device as claimed in claim 11, **characterized in that** each of said moving portions supports at least one vaporization source.

13. Device as claimed in claim 11 or 12, **characterized in that** each of said moving portions supports at least one diffuser.

14. Device as claimed in claim 11, 12 or 13, **characterized in that** said fixed portion contains said two electrodes.

15. Device as claimed in one or more of claims 11 to 14, **characterized in that** said fixed portion and said moving portions each have a substantially cylindrical wall.

16. Device as claimed in one or more of claims 11 to 15, **characterized in that** said fixed portion of the vacuum chamber comprises a prismatic side wall and **in that** said electrodes are positioned at the level of the inner angles of said prismatic wall.

17. Device as claimed in one or more of the previous claims, **characterized in that** four holder units for the parts to be processed are positioned in said vacuum chamber.

18. Device as claimed in one or more of the previous claims, **characterized in that** said electrodes are fixed to an upper wall of said vacuum chamber, said chamber having a vertical extension.

19. Device as claimed in one or more of the previous claims, **characterized in that** said pumping system comprises a primary pumping unit, at least one diffusion pump and at least one cryogenic panel.

20. Device as claimed in claim 19, **characterized in that** said primary pumping unit comprises one or more mechanical pumps.

21. Device as claimed in claim 20, **characterized in that** said pumping unit comprises at least one lobe pump, positioned downstream of which is at least one further mechanical pump.

22. Device as claimed in claim 19, 20 or 21, **characterized in that** said diffusion pump is connected to the inside of the vacuum chamber by a suction duct, and **in that** positioned along said suction duct is a first shut-off valve, to isolate the diffusion pump from a volume inside which said cryogenic panel is located.

23. Device as claimed in claim 22, **characterized in that** said cryogenic panel is located inside said suction duct that connects the vacuum chamber to the diffusion pump.

24. Device as claimed in claim 23, **characterized in that** a second shut-off valve is positioned in said suction duct, to isolate the volume in which the cryogenic panel is positioned from the inside of the vacuum chamber, said cryogenic panel being positioned between the first and the second shut-off valve.

25. Device as claimed in claim 22, 23 or 24, **characterized in that** said first shut-off valve comprises a closing element movable in a plane substantially orthogonal to said suction duct.

26. Device as claimed in claim 25, **characterized in that** said movable closing element is provided with an oscillatory movement to open and close said suction duct.

27. Device as claimed in claim 24, **characterized in that** said second shut-off valve comprises an oscillating closing element.

28. Device as claimed in one or more of the previous claims, **characterized in that** said holders are distributed about a central crown gear, with which pinions coaxial with the holders mesh.

29. Device as claimed in claim 28, **characterized in that** said pinions and said holders are supported by at least one rotating disk coaxial with said ring gear.

30. Device as claimed in claim 29, **characterized in that** said at least one disk comprises a moving sector to be moved away from the axis of said disk, said moving sector supporting at least one pinion with a respective part holder, the movement of said sector with the respective holder facilitating access to the central area between the holders positioned on the disk.

31. A method of producing a metallization layer and a protective coating on parts in a vacuum chamber, comprising the steps of:
- placing the parts to be metallized in the vacuum chamber;
- generating in said vacuum chamber a degree of vacuum sufficient for metallization, by means of at least a primary pump and a diffusion pump;
- metallizing the parts keeping said degree of vacuum in said chamber;
- at the end of the metallization step, isolating the diffusion pump from the inside of the vacuum chamber and introducing into said vacuum chamber at least a first fluid to form a protective coating of the metallization layer formed on the parts, keeping a cryogenic panel active to reduce the presence of dampness in said vacuum chamber, while said diffusion pump is kept isolated from said vacuum chamber.

32. Method as claimed in claim 31, wherein said fluid comprises a monomer.

33. Method as claimed in claim 32, wherein said first fluid is a monomer and wherein said monomer is energized by a plasma generated by said two electrodes and then deposited on the surface of the parts to be coated which pass through the volume in which said plasma is generated, to form a protective polymer coating.

34. Method as claimed in claim 31, 32 or 33, wherein a second fluid is introduced into said chamber.

35. Method as claimed in claim 34, wherein said second fluid is an inert gas.

36. Method as claimed in claim 34 or 35, comprising a step for surface activation of the parts, prior to metallization, said preliminary cleaning step being obtained by introducing an inert gas into said vacuum chamber and generating a glow discharge using said electrodes.

37. Method as claimed in claim 36, wherein said cryogenic panel is kept active during said surface activation step.

38. Method as claimed in claim 36 or 37, wherein during said surface activation step the diffusion pump is kept isolated from the vacuum chamber.

39. Method as claimed in one or more of claims 31 to 38, wherein said cryogenic panel is kept active during the metallization step.

40. Method as claimed in one or more of claims 31 to 39, wherein to generate said sufficient degree of vacuum for metallization in said chamber the following steps are performed:
a) activating at least one primary pump;
b) reaching a first degree of vacuum;
c) activating the cryogenic panel;
d) reaching a second degree of vacuum, higher than the first degree of vacuum and activating the diffusion pump.

41. A method for metallizing parts in a vacuum chamber, comprising the steps of:
- placing the parts to be metallized in the vacuum chamber;
- generating a first degree of vacuum in said vacuum chamber by means of at least one primary pump;
- activating a cryogenic panel in connection with the inside of said vacuum chamber;
- further increasing the degree of vacuum from said first degree of vacuum to a second degree of vacuum, sufficient to activate at least one diffusion pump;
- reaching a sufficient degree of vacuum for metallization;
- metallizing the parts keeping said degree of vacuum in said chamber.

42. A vacuum metallization device, comprising a vacuum chamber and a pumping system with at least a primary pump, a diffusion pump and a cryogenic panel, wherein the diffusion pump is connected to the inside of the vacuum chamber by means of a suction duct; **characterized in that** positioned along the suction duct is a first shut-off valve to isolate the diffusion pump from a volume, inside which the cryogenic panel is located, said volume being in connection with the vacuum chamber.

43. Device as claimed in claim 42, wherein said volume in which the cryogenic panel is located is isolatable from the inside of the vacuum chamber by means of a second valve.

44. Device as claimed in claim 42 or 43, **characterized in that** said first valve has a substantially flat closing element, movable in a plane orthogonal to the suction duct.

45. Device as claimed in claim 42, 43 or 44, **characterized in that** said second valve has an oscillating closing element.
